Europäisches Patentamt

European Patent Office

Office européen des brevets

(19)

(11) Veröffentlichungsnummer: **0 183 230 B1**

(12) **EUROPÄISCHE PATENTSCHRIFT**

(45) Veröffentlichungstag der Patentschrift:
08.02.89

(21) Anmeldenummer: 85114999.7

(22) Anmeldetag: 26.11.85

(51) Int. Cl.⁴: **C 23 C 8/36, H 01 J 37/32**

(54) Verfahren und Vorrichtung zur Steuerung der chemisch-thermischen Behandlung von Werkstücken mittels Glimmentladung in einem Behandlungsgas.

(30) Priorität: 26.11.84 BG 67672/84

(43) Veröffentlichungstag der Anmeldung:
04.06.86 Patentblatt 86/23

(45) Bekanntmachung des Hinweises auf die Patenterteilung:
08.02.89 Patentblatt 89/6

(84) Benannte Vertragsstaaten:
CH DE FR GB LI SE

(56) Entgegenhaltungen:
DE-B- 1 029 213
DE-B- 1 029 641
DE-B- 1 068 972
FR-A- 1 147 934
FR-A- 1 541 370
FR-A- 2 341 892
FR-A- 2 342 000
GB-A- 2 034 921
US-A- 4 396 478

PATENTS ABSTRACTS OF JAPAN, Band 3, Nr. 59 (C-46), Seite 124C46, 19. Mai 1979; & JP-A-54 35138 (ISHIKAWAJIMA HARIMA JUKOGYO K.K.) 15-03-1979
PATENTS ABSTRACTS OF JAPAN, Band 3, Nr. 59 (C-46) Seite 124C46, 19. Mai 1979; & JP-A-54 35137 (ISHIKAWAJIMA HARIMA JUKOGYO K.K.) 15-03-1979

(73) Patentinhaber: V M E I "LENIN", Quartal Darvenitza, BG-1156 Sofia (BG)

(72) Erfinder: Savov, Svetoslav Alexandrov, Dipl.-Ing., Complex Mladost, Bl.90, Sofia (BG)
Erfinder: Mintchev, Mintcho Savov, Dipl.-Ing., Boul. Bulgaria, 100, Sofia (BG)
Erfinder: Nitchev, Peter Todorov, Dipl.-Ing., Suhodolska-Strasse 2, Sofia (BG)
Erfinder: Shivarov, Georgi Stefanov, Dipl.-Ing., Complex Mladost-3, Bl.339, Sofia (BG)

(74) Vertreter: Ebbinghaus, Dieter et al, v. FÜNER, EBBINGHAUS, FINCK Patentanwälte European Patent Attorneys Mariahilfplatz 2 & 3, D-8000 München 90 (DE)

**Beschreibung**

Die Erfindung betrifft ein Verfahren und eine Vorrichtung zur Steuerung der chemisch-thermischen Behandlung von Werkstücken mittels Glimmentladung in einer Behandlungsgas-Atmosphäre zur Anwendung im Maschinenbau, z.B. bei der Steuerung des Behandlungsprozesses beim Nitrieren von Maschinenteilen in Glimmnitrieranlagen.

Es ist ein Verfahren zur Steuerung der chemisch-thermischen Behandlung von Werkstücken mittels Glimmentladung in einem Behandlungsgas bekannt, das zwei Verfahrensstufen umfasst: Werkstückerwärmung mit gleichzeitiger intensiver Kathodenzerstäubung ihrer Oberfläche und Diffusionsanreicherung der Werkstücke. In beiden Verfahrensstufen werden die Temperatur der in der Arbeitskammer befindlichen Werkstücke, die Änderungsgeschwindigkeit der Temperatur und die Häufigkeit der entstehenden Bogenentladungen gemessen. Die erhaltenen Werte werden mit den entsprechenden Werten verglichen und dadurch Fehlersignale erhalten, die zur Erzeugung von Steuersignalen für die Mittel- und Amplitudenwerte der Glimmentladungsspannung dienen, wobei das Steuersignal des Amplitudenwertes der Spannung die Häufigkeit der Bogenentladungen so reguliert, dass sie der vorgegebenen entspricht, und wobei das Steuersignal des Mittelwertes der Spannung die Temperatur der behandelten Werkstücke so reguliert, dass sie der vorgegebenen entspricht.

Nachteile dieses Verfahrens zur Steuerung der chemisch-thermischen Behandlung mittels Glimmentladung in Behandlungsgasen sind die niedrige Effektivität der Kathodenzerstäubung während der Erwärmung, weil es nicht möglich ist, einen Amplitudenwert der Glimmentladungsspannung vorzugeben, der der vorher vorgegebenen Intensität der Kathodenzerstäubung entspricht. Ein anderer Nachteil des Verfahrens ist der komplizierte Algorithmus der Steuerung, der verlangt, gleichzeitig den Mittel- und den Amplitudenwert der Spannung zu steuern. Wesentlicher Nachteil ist auch die Unmöglichkeit, eine befriedigende Reproduzierbarkeit des Behandlungsergebnisses zu erhalten, weil nur die Temperatur der Werkstücke und die Häufigkeit der Bogenentladungen stabilisiert werden. Andere für das Behandlungsergebnis qualitätsbestimmende Grössen (Einflussfaktoren) werden nicht berücksichtigt.

Es ist eine Vorrichtung zur Steuerung der chemisch-thermischen Behandlung von Werkstücken mittels Glimmentladung in einem Behandlungsgas bekannt, die aus einer Spannungsquelle mit einem Ausgang und zwei Eingängen zur Steuerung besteht, wobei der erste Eingang zur Steuerung des Mittelwertes der Spannung und der zweite zur Steuerung des Amplitudenwertes der Spannung dienen. Die Vorrichtung enthält einen Datengeber zum Messen der Temperatur, der wärmeleitend mit den Werkstücken verbunden ist und dessen Ausgang über eine Reihenschaltung aus einem Element zum Messen der Änderungsgeschwindigkeit der Temperatur, einem Vergleichselement für die Änderungsgeschwindigkeit der Temperatur und einem Thermoregler mit dem ersten Eingang des Steuerblocks verbunden ist.

Der Ausgang des Temperaturdatengebers ist über eine Reihenschaltung aus einer zweiten Vergleichsvorrichtung und einem zweiten Thermoregler mit dem zweiten Eingang des Steuerblocks verbunden. Der Ausgang des zweiten Vergleichselementes ist mit dem dritten Eingang des Steuerungsblocks und der Eingang des Spannungsumwandlers mit dem Quellenausgang der Speisespannung verbunden. Der Ausgang des Umwandlers ist mit dem vierten Eingang des Steuerblocks mittels einer Reihenschaltung aus einem Häufigkeits-Spannungswandler, einem dritten Vergleichselement und einem dritten Regler mit dem fünften Eingang des Steuerblocks verbunden. In der Schaltung der Speisespannungsquelle mit der Arbeitskammer ist ein Stromdatengeber in Reihe geschaltet. Der Ausgang dieses Stromdatengebers ist mit dem zweiten Eingang des Datengebers für die Häufigkeit der Bogenentladungen verbunden. An die zweiten Eingänge der Vergleichselemente sind Geber für vorgegebene Werte der Temperatur der behandelten Werkstücke, der Geschwindigkeit ihrer Änderung bzw. der Häufigkeit der entstehenden Bogenentladungen angeschlossen.

Ein Nachteil dieser Vorrichtung ist die komplizierte Schaltung, die einem komplizierten Arbeitsalgorithmus entspricht, sowie die Verwendung einer Speisequelle mit zwei Steuerungseingängen.

Aufgabe der Erfindung ist es, ein Verfahren und eine Vorrichtung zur Steuerung der chemisch-thermischen Behandlung von Werkstücken mittels Glimmentladung in einer Atmosphäre aus Behandlungsgas zu schaffen, bei denen die Effektivität der Kathodenzerstäubung erhöht, die Kompliziertheit des Steuerungsalgorithmus und des Vorrichtungsschemas verringert, die Werkstücke vor der Einwirkung der entstehenden Bogenentladungen besser geschützt und eine bessere Reproduzierbarkeit der Behandlungsergebnisse erreicht werden.

Diese Aufgabe wird erfindungsgemäss durch das im Patentanspruch 1 beschriebene Verfahren bzw. die im Patentanspruch 2 beschriebene Vorrichtung gelöst.

Die Vorteile des erfindungsgemässen Verfahrens und der erfindungsgemässen Vorrichtung zur Steuerung der chemisch-thermischen Behandlung von Werkstücken mit Glimmentladung in einer Atmosphäre von Behandlungsgas sind die gesteigerte Effektivität der Kathodenzerstäubung während der Erwärmung, die durch die Verwendung einer vorher ausgewählten konstanten Spannung erreicht wird, Vereinfachung des Steuerungsalgorithmus und des Aufbaues der Vorrichtung durch Verwendung einer elektrischen Energiequelle mit konstanter Spannung mit einem Steuereingang der Spannung, Dosieren der Behandlungsgase, indem vorher vorgegebene Spannungswerte der Glimmentladung verwendet werden, die den einzelnen Gasen entsprechen. Vorteile sind auch der verbesserte Schutz der behandelten Werkstücke vor den entstehenden Bogenentladungen durch Verwendung eines Entladungsstromes, der seinen Wert während der Dauer der Bogenentladung nicht ändert und die bessere Reproduzierbarkeit der im Ergebnis der Behandlung erreichten Werkstückeigenschaften durch Anwendung von vorher vorgegebenen Werten der Werkstücktemperatur und der Spannung der Glimmentladung.

Die Erfindung wird anhand der in der Zeichnung gezeigten Ausführungsbeispiele näher erläutert. Es zeigt

Fig. 1 das Schaltbild der Vorrichtung,

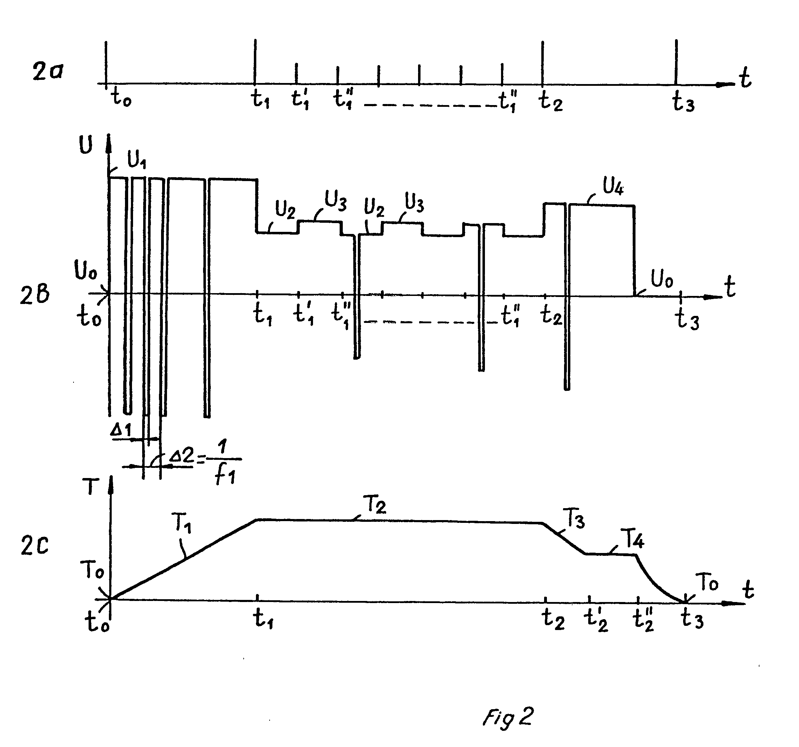

Fig. 2a die Reihenfolge und die Dauer der Verfahrensstufen und die aufeinanderfolgende Anwendung der Behandlungsgase,

Fig. 2b die zeitliche Spannungsänderung am elektrischen Eingang der Arbeitskammer und

Fig. 2c die zeitliche Temperaturänderung der behandelten Werkstücke.

Das Verfahren zur chemisch-thermischen Behandlung der Werkstücke mittels Glimmentladung in Behandlungsgasen umfasst folgende Schritte:

1.) Erwärmung der Werkstücke mit gleichzeitiger intensiver Kathodenzerstäubung ihrer Oberfläche während der Zeit $t_0$ bis $t_1$;

2.) Diffusionsanreicherung bei vorgegebener konstanter Temperatur während der Zeit von $t_1$ bis $t_2$;

3.) Abkühlung während der Zeit von $t_2$ bis $t_3$.

Die Dauer der einzelnen Verfahrensschritte $t_1-t_0$, $t_2-t_1$ und $t_3-t_2$ wird vorher vorgegeben. Während der Verfahrensschritte werden bestimmte Behandlungsgase verwendet, wobei in der Zeitspanne $t_1-t_0$ ein erstes, in $t_2-t_1$ ein zweites bzw. drittes und in $t_3-t_2$ ein viertes Behandlungsgas verwendet werden. Am Anfangsmoment $t_0$ hat die Temperatur der behandelten Werkstücke T den Anfangswert $T_0$ und die Spannung am elektrischen Eingang der Arbeitskammer erreicht vom Nullwert $U_0$ den vorher vorgegebenen ersten Wert der Glimmentladungsspannung $U_1$. In der Arbeitskammer wird mit dem ersten Behandlungsgas gearbeitet. Im Zeitpunkt $t_1$ erreicht die Werkstücktemperatur den vorher vorgegebenen konstanten Wert $T_2$ und die Spannung sinkt vom Wert $U_1$ auf den vorher vorgegebenen zweiten Wert $U_2$. Das erste Behandlungsgas wird vom zweiten ersetzt. Nach dem Zeitpunkt $t_1$ hat die Spannung den Wert $U_2$ und den vorher vorgegebenen dritten Wert $U_3$, welchen Werten die vorher vorgegebenen Intervalle $t_1'-t_1$ und $t_1''-t_1'$ entsprechen, in denen das zweite bzw. dritte Behandlungsgas verwendet werden. Durch sich wiederholendes Dosieren des zweiten und des dritten Gases in den Zeitspannen $t_1'-t_1$ bzw. $t_1''-t_1'$ wird das vorgegebene Mengenverhältnis zwischen den zwei durchfliessenden Gasen eingestellt. Vom Zeitpunkt $t_1$ bis $t_2$ hat die Werkstücktemperatur T einen vorgegebenen Wert $T_2$. Im Zeitpunkt $t_2$ hat die Werkstücktemperatur T den Wert $T_2$ und die Glimmentladungsspannung erreicht den vorgegebenen vierten Wert $U_4$, wobei auch das dritte Behandlungsgas vom vierten ersetzt wird. Im Zeitpunkt $t_2'$ ist die Temperatur $T_3$ auf den vorgegebenen zweiten konstanten Wert $T_4$ gesunken und im Zeitpunkt $t_2''$ hat die Temperatur T den vorgegebenen Wert $T_4$, die Spannung mit dem vorgegebenen Wert $U_4$ sinkt auf den Nullwert $U_0$ und die Zufuhr des vierten Behandlungsgases in die Arbeitskammer wird unterbrochen.

Im Zeitpunkt $t_3$ ist die Temperatur T auf den Anfangswert $T_0$ gesunken. Damit ist auch das Ende der Behandlung erreicht. Während der Verfahrensschritte werden folgende Grössen gemessen: Werkstücktemperatur, Spannung am elektrischen Eingang der Arbeitskammer, Strom durch die Arbeitskammer und Häufigkeit der entstehenden Bogenentladungen. Die dadurch gewonnenen Signale werden mit den entsprechenden, vorgegebenen Werten der Temperatur, der Spannung und der Häufigkeit verglichen. Die daraus resultierenden Fehlersignale dienen zur Erzeugung von entsprechenden Steuersignalen, die weiterhin zur Regelung der Temperatur, der Spannung und der Häufigkeit verwendet werden. Während der Erwärmung hat die Spannung mindestens einen konstanten Wert, der mindestens einem vorgegebenen Wert $U_1$ entspricht, bei dem die Kathodenzerstäubung der Werkstücke eine vorgegebene Intensität aufweist. Während der Diffusionsanreicherung bei vorgegebener Temperatur hat die Spannung mindestens zwei andere konstante Werte, die den vorgegebenen Werten $U_2$ und $U_3$ entsprechen, wobei die notwendigen Werkstückeigenschaften erreicht werden. Während der Abkühlung hat die Spannung mindestens einen vierten konstanten Wert, der dem vorgegebenen Wert $U_4$ entspricht, wobei die endgültigen Eigenschaften der Werkstücke erreicht werden. Während einzelner Verfahrensstufen hat die Häufigkeit der Bogenentladungen einen willkürlichen Wert, welcher vom Grad der Unreinheit der Werkstückoberfläche im Zeitpunkt $t_0$ der Behandlung abhängt, sowie von Zufallsfaktoren bis zum Zeitpunkt $t_3$ beeinflusst wird. Die Häufigkeit der entstehenden Bogenentladungen wird durch den Umkehrwert der Wiederholungsperiode der Bogenentladungen $\triangle 2$ ausgedrückt. Die Dauer der Bogenentladung hat den Wert $\triangle 1$. Am Anfang der Behandlung ist der Wert der Häufigkeit der entstehenden Bogenentladungen nicht grösser als der Wert der vorgegebenen Häufigkeit $f_1$.

Die Temperatur hat immer einen dem vorgegebenen anwachsenden Wert $T_1$ entsprechenden Wert, konstante Werte $T_2$ und $T_4$ und sinkenden Wert $T_3$, welche vorgegebenen Werte den einzelnen Verfahrensschritten entsprechen. Als Beispiel wird während der Abkühlung ein zweiter konstanter Wert $T_4$ verwendet, zu dem Zweck, die Temperatur in der Zeit $t_2''-t_2'$ beizubehalten. Der Temperaturwert wird während der einzelnen Schritte in bestimmter Weise in Übereinstimmung mit dem Spannungswert gebracht. So wird eine Kathodenzerstäubung mit vorgegebener Intensität erreicht und dadurch die notwendigen und endgültigen Eigenschaften der Werkstücke erzeugt. Die Behandlungsgase sind zweckmässigerweise als erstes, zweites, drittes und viertes Behandlungsgas geordnet. Dieser Reihenfolge entsprechen auch die vorgegebenen Spannungswerte $U_1$, $U_2$, $U_3$ und $U_4$. Die Spannung der Glimmentladung wird mittels Durchflussregelung der Behandlungsgase gesteuert. Die Häufigkeit der Bogenentladungen und die Temperatur der Werkstücke werden mittels des Stromes geregelt. Dabei wird das dem Stromwert entsprechende Signal mit dem Additionssignal verglichen, das durch Aufsummieren des mit der Häufigkeit verbundenen Steuersignals mit dem mit der Temperatur verbundenen Steuersignal erhalten wird. Der Vergleich ergibt ein Fehlersignal, das zur Erzeugung eines Steuersignals dient, das wiederum in der erwähnten Weise mit der Temperatur und der Häufigkeit verbunden ist. Dieses Steuersignal dient zur Steuerung der Gleichspannungsquelle derart, dass der Strom dem Wert des Additionssignals entspricht. Gleichzeitig mit der Regelung der Temperatur werden die Spannung am elektrischen Eingang der Arbeitskammer gemessen und die dem Häufigkeitswert und dem Spannungswert entsprechenden Signale erzeugt. Diese Signale werden mit denen verglichen, die den vorgegebenen Werten der Häufigkeit $f_1$ und der Spannung $U_1$, $U_2$, $U_3$, $U_4$ entsprechen. Nach dem Vergleich werden entsprechende Fehlersignale erhalten, die zur Erzeugung entsprechender Steuersignale dienen, wobei das Steuersignal der Häufigkeit auf die erwähnte Weise mit dem Steuersignal der Temperatur aufsummiert wird. Das Steuersignal der Spannung dient zur Durchflussregelung des ersten, zweiten, dritten bzw. vierten Behandlungsgases, die durch die Reihenschaltung aus Arbeitskammer und arbeitender Vakuumpumpe in die Atmosphäre geleitet werden. Die Reihenfolge beim Durchlassen der Gase entspricht einem Signal zur Auswahl des jeweiligen Behandlungsgases. Die Durchflussregelung dient zur Erzeugung eines Druckes in der Arbeitskammer, dessen Wert dem der Spannung entspricht.

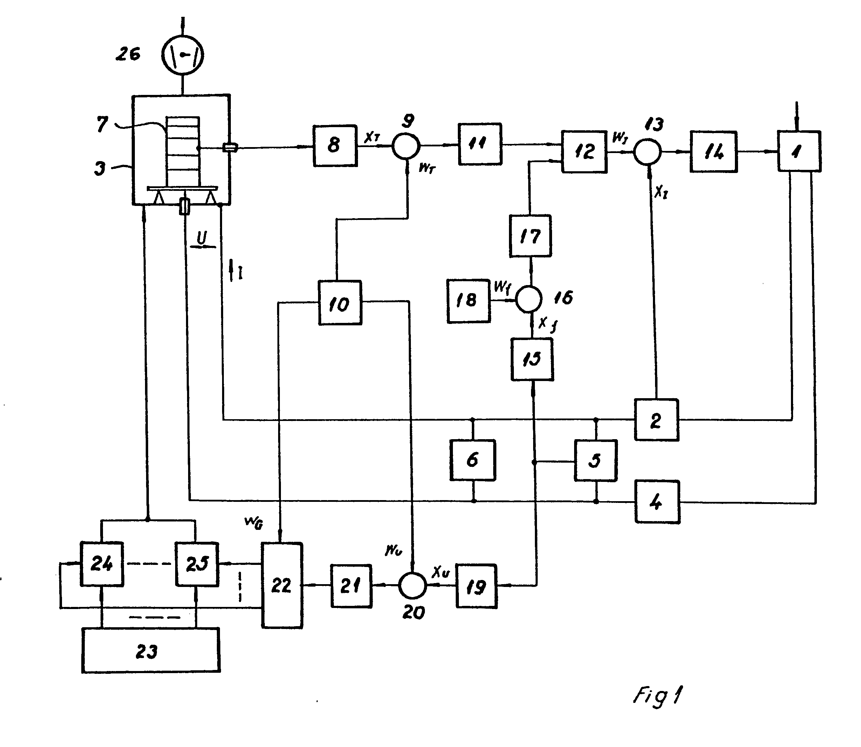

Fig. 1 zeigt die Vorrichtung zur Steuerung der chemisch-thermischen Behandlung von Werkstücken mittels Glimmentladung in eine Atmosphäre von Behandlungsgasen. Sie besteht aus einer Gleichspannungsquelle 1, deren erster Ausgangspol über einen Stromdatengeber 2 mit dem entsprechenden Pol am elektrischen Eingang der Arbeitskammer 3 und deren zweiter Ausgangspol über eine Glättungsdrossel 4 mit dem anderen Eingangspol der Arbeitskammer 3 verbunden sind. Parallel zum elektrischen Eingang der Arbeitskammer 3 sind ein Spannungsdatengeber 5 und ein Element 6 zum Unterbrechen der Bogenentladungen geschaltet. Die behandelten Werkstücke 7 sind wärmeleitend mit einem Temperaturdatengeber 8 verbunden, dessen Ausgang mit dem ersten Eingang des ersten Vergleichselements 9, dessen zweiter Eingang mit dem ersten Ausgang für die vorgegebene Temperatur des Programmierelementes 10 verbunden sind. Der Ausgang des ersten Vergleichselements 9 ist mittels eines ersten Reglers 11 mit dem ersten Eingang eines Addiererelementes 12 verbunden, dessen Ausgang mit dem ersten Eingang eines zweiten Vergleichselementes 13 verbunden ist. Der zweite Eingang des Vergleichselementes 13 ist mit dem Ausgang des Stromdatengebers 2 verbunden und sein Ausgang ist mittels eines zweiten Reglers 14 mit dem Steuereingang der Konstantspannungsquelle 1 verbunden. Der Ausgang des Spannungsdatengebers 5 ist mittels eines Frequenzspannungswandlers 15 mit dem ersten Eingang eines dritten Vergleichselementes 16 verbunden, dessen Ausgang mittels eines dritten Reglers 17 mit dem zweiten Eingang des Addiererelementes 12 verbunden ist. Der zweite Eingang des dritten Vergleichselementes 16 ist mit der Quelle 18 für den vorgegebenen konstanten Wert der Häufigkeit verbunden. Der Ausgang des Spannungsdatengebers 5 ist mittels eines Amplitudendetektors 19 mit dem ersten Eingang eines vierten Vergleichselementes 20 verbunden. Der Ausgang des Vergleichselementes 20 ist mittels eines vierten Reglers 21 mit dem ersten Eingang eines Umschalters 22 verbunden, dessen zweiter Steuereingang mit dem zweiten Ausgang für das vorgegebene Behandlungsgas des Programmierelementes 10 verbunden ist. Der dritte Ausgang des Programmierelementes 10 zur Vorgabe des Amplitudenwerts der Spannung ist mit dem zweiten Eingang des vierten Vergleichselementes 20 verbunden. Die Ausgänge der Behandlungsgasquelle 23 sind an die Gaseingänge von mindestens zwei Ausführungsorganen 24 bzw. 25 zur Durchflussregelung angeschlossen, deren Ausgänge mit dem Gaseingang der Arbeitskammer 3 verbunden sind. Die Eingänge zur Steuerung der Ausführungsorgane 24 bzw. 25 der Durchflussregelung sind mit den entsprechenden Ausgängen des Umschalters 22 verbunden. Der Gasausgang der Arbeitskammer 3 ist mittels einer Vakuumpumpe 26 mit Atmosphäre verbunden.

Die Funktionsweise der erfindungsgemässen Vorrichtung ist folgende:

Bis zum Zeitpunkt $t_0$ ist infolge der Arbeit der Vakuumpumpe 26, bei gleichzeitig gesperrten Ausführungsorganen der Durchflussregelung 24 bzw. 25, der Druck in der Arbeitskammer 3 möglichst klein; sein Wert ist von der Qualität der Vakuumpumpe 26 und der Arbeitskammer 3 abhängig. In dem Temperatur-Programmierelement 10 sind die vorgegebenen Werte der Spannung $U_1$, $U_2$, $U_3$, $U_4$, die Temperatur der behandelten Werkstücke $T_1$, $T_2$, $T_3$, $T_4$, die vorgegebene Reihenfolge der Anwendung der Behandlungsgase, die Dauer der einzelnen Etappen $t_1-t_0$, $t_2-t_1$, $t_3-t_2$ und die Dauer $t_1'-t_1$, $t_1''-t_1'$ eingegeben. Im Zeitpunkt $t_0$ beginnt die chemisch-thermische Behandlung der Werkstücke 7. Die Ausgangsspannung der elektrischen Konstantspannungsquelle erregt in der Arbeitskammer 3 eine Glimmentladung mit einer Spannung, die vom Spannungsdatengeber 5 gemessen wird. Die entstehenden Bogenentladungen werden von dem Element zum Unterbrechen der Bogenentladungen 6 unterbrochen. Im Ergebnis der Funktion des Elementes zum Unterbrechen der Bogenentladungen 6 ändert sich die Spannung am elektrischen Eingang der Arbeitskammer 3; sie hat Impulsform und Amplitudenwerte, die der Spannung der Glimmentladung entsprechen. Der Amplitudendetektor 19 trennt den Spannungswert der Glimmentladung. An seinem Ausgang wird ein Signal $x_u$ erhalten, das dem Spannungswert entspricht. Das vierte Vergleichselement 20 vergleicht das Signal $x_u$ mit dem Signal $w_u$, das den vorgegebenen Spannungswerten der Glimmentladung $U_1$, $U_2$, $U_3$, $U_4$ in den einzelnen Etappen entspricht. Nach dem Vergleich wird ein Fehlersignal erhalten, aus dem der vierte Regler 21 ein viertes Steuersignal erzeugt. Das vierte Steuersignal wird über den Umschalter 22 an den Eingang des Ausführungsorgans 24 bzw. 25 zur Regelung des Durchflusses des ersten Behandlungsgases geleitet. Der Umschalter 22 befindet sich in einer Position, die dem Signal $w_G$ entspricht, mit dem die Wahl des Behandlungsgases getroffen wird. Falls das Signal $x_u$ kleiner als das Signal $w_u$ ist, wird das Ausführungsorgan 24 bzw. 25 geöffnet und in die Arbeitskammer 3 beginnt Arbeitsgas einzuströmen. Der Wert der Durchflussmenge des Behandlungsgases entspricht dem Wert des vierten Steuersignals $w_G$. Mit dem Einströmen des Gases in die Arbeitskammer 3 steigt in ihr der Druck und es wird zugleich eine Erniedrigung der Spannung hervorgerufen, die wieder vom Spannungsdatengeber 5 gemessen wird. Die Spannung der Glimmentladung sinkt bis zum Erreichen des vorgegebenen Wertes $U_1$. Während der nächsten Stufen erfolgt die Steuerung der Glimmentladungsspannung in der erwähnten Weise, wobei konstante Spannungswerte entsprechend den vorgegebenen $U_2$, $U_3$ und $U_4$ festgelegt werden. Am Ausgang des Frequenzspannungswandlers 15 wird das Signal $x_f$ erhalten, das dem Häufigkeitswert der entstehenden Bogenentladungen entspricht. Das dritte Vergleichselement 16 vergleicht das Signal $x_f$ mit dem Signal $w_f$, das dem vorgegebenen Häufigkeitswert der Bogenentladungen $f_1$ entspricht. Aus dem erhaltenen Fehlersignal erzeugt der dritte Regler 17 ein zweites Steuersignal. Am Ausgang des Temperaturdatengebers 8 wird das Signal $x_T$ erhalten, das dem Temperaturwert der Werkstücke 7 entspricht. Das erste Vergleichselement 9 vergleicht das Signal $x_T$ mit dem Signal $w_T$, das den vorgegebenen Werten $T_1$, $T_2$, $T_3$ und $T_4$ in den einzelnen Verfahrensstufen entspricht. Aus dem erhaltenen Fehlersignal erzeugt der erste Regler 11 ein erstes Steuersignal. Das Addierelement 12 summiert das erste und das zweite Steuersignal und leitet das Additionssignal zum ersten Eingang des zweiten Vergleichselements 13. Das zweite Vergleichselement 13 vergleicht das Additionssignal, in seiner Eigenschaft als vorgegebenes Signal $w_1$, mit dem Signal $x_1$. Das Signal $x_1$ entspricht dem gemessenen Wert des Entladungsstromes I. Aus dem erhaltenen Fehlersignal erzeugt der zweite Regler 14 ein drittes Steuersignal. Das dritte Steuersignal steuert die Spannung am Ausgang der Gleichspannungsquelle 1 derart, dass der Strom in der Arbeitskammer 3 einen dem vorgegebenen Signal $w_1$ entsprechenden Wert hat. $W_1$ ist die Summe der Steuersignale für die Häufigkeit der entstehenden Bogenentladungen $f_1$ und die Temperatur der behandelten Werkstücke $T_1$, $T_2$, $T_3$ und $T_4$ während der Verfahrensschritte.

## Patentansprüche

1. Verfahren zur Steuerung der chemisch-thermischen Behandlung von Werkstücken mittels Glimmentladung in einer Atmosphäre von Behandlungsgasen, durch Erwärmung der Werkstücke bei gleichzeitiger intensiver Kathodenzerstäubung ihrer Oberfläche und durch Diffusionsanreicherung der Werkstücke, wobei die Temperatur der Werkstücke und die Häufigkeit der entstehenden Bogenentladungen gemessen, die gemessenen Werte mit dem vorgegebenen verglichen und daraus Fehlersignale erzeugt werden, die zum Erzeugen von Steuersignalen dienen, dadurch gekennzeichnet, dass während der Erwärmung der Werkstücke bei gleichzeitiger intensiver Kathodenzerstäubung ihrer Oberfläche die Spannung der Glimmentladung mindestens einen konstanten Wert hat, der einem vorgegebenen entspricht, bei dem die Kathodenzerstäubung der Werkstücke mit vorgegebener Intensität abläuft, dass während der Diffusinsanreicherung der Werkstücke bei vorgegebener Temperatur die Spannung der Glimmentladung einen anderen, mindestens einen konstanten Wert hat, der mindestens einem vorgegebenen Wert entspricht, bei dem die gewünschten Eigenschaften der Werkstücke erhalten werden, dass während der Abkühlung die Spannung der Glimmentladung mindestens einen dritten konstanten Wert hat, der mindestens einem vorgegebenen Wert entspricht, bei dem die endgültigen Eigenschaften der Werkstücke erhalten werden, dass während der genannten Verfahrensstufen die Häufigkeit der entstehenden Bogenentladungen einen beliebigen Wert hat, deren Grösse auf einen vorgegebenen konstanten Wert der Häufigkeit der Bogenentladungen begrenzt wird, dass die Temperatur der Werkstücke immer einem vorgegebenen, wachsenden, konstanten und sinkenden Wert entspricht, welcher zusammen mit dem erwähnten, mindestens einen vorgegebenen Wert der Spannung der Glimmentladung, die vorgegebene Intensität der Kathodenzerstäubung und die angestrebten endgültigen Eigenschaften der Werkstücke gewährleistet, dass während der Verfahrensstufen Behandlungsgase in einer Folge verwendet werden die der Reihe vorgegebener Spannungswerte der Glimmentladung entspricht, welche Spannung durch den Durchfluss der Behandlungsgase gesteuert wird, dass während jeder Verfahrensstufe ausser der Temperatur der Werkstücke und der Häufigkeit der entstehenden Bogenentladungen noch der Strom der Glimmentladung und der Amplitudenwert der Spannung der Glimmentladung gemessen werden, dass ausser den gemessenen Temperaturwerten der Werkstücke und der Häufigkeit der Bogenentladungen auch der Strom der Glimmentladung und der Amplitudenwert der Spannung der Glimmentladung mit ihren vorgegebenen Werten verglichen werden und von den erhaltenen Fehlersignalen für die Temperatur und Häufigkeit entsprechende Steuersignale für die Temperatur und die Häufigkeit gewonnen und summiert werden, dass das Additionssignal mit einem dem Entladungsstrom proportionalen Signal verglichen wird, und dass dadurch ein Fehlersignal erhalten und von ihm ein Steuersignal für die Spannung der Glimmentladung erzeugt wird, so dass der Strom der Glimmentladung dem Additionssignal der Steuersignale der Temperatur und der Häufigkeit nach einem PID-Gesetz entspricht und vom Fehlersignal der Amplitudenwert der Spannung der Glimmentladung ein Steuerungssignal für den Durchfluss des Behandlungsgases erzeugt wird, so dass der Amplitudenwert der Spannung der Glimmentladung dem vorgegebenen Wert nach einem weiteren PID-Gesetz entspricht.

2. Vorrichtung zur Steuerung der chemisch-thermischen Behandlung von Werkstücken mit Glimmentladung in einer Atmosphäre von Behandlungsgas, zur Durchführung des Verfahrens nach Anspruch 1, mit einer Gleichspannungsquelle (1), mit einer Arbeitskammer (3) zur Aufnahme der Werkstücke (7), die mit einem Temperaturdatengeber (8) wärmeleitend verbunden sind, der mittels eines ersten Vergleichselementes (9) mit einem ersten Regler (11) verbunden ist, wobei der Gasausgang der Arbeitskammer (3) mittels einer Vakuumpumpe (26) mit der Aussenatmosphäre verbunden ist, und mit einem Spannungsdatengeber (5), dessen Ausgang über einen in Reihe geschalteten Frequenz-Spannungs-Umwandler (15) und ein drittes Vergleichselement (16) mit dem Eingang eines dritten Reglers (17) verbunden ist, und wobei eine Quelle (18) für einen vorgegebenen, konstanten Wert der Häufigkeit der Bogenentladungen mit dem zweiten Eingang des dritten Vergleichselements (16) verbunden ist, dadurch gekennzeichnet, dass der eine Pol der Gleichspannungsquelle (1) mittels eines Stromdatengebers (2) mit dem entsprechenden Pol des elektrischen Eingangs der Arbeitskammer (3) verbunden ist, dass der andere Pol der Gleichspannungsquelle (1) mittels einer Glättungsdrossel (4) mit dem anderen Pol des elektrischen Eingangs der Arbeitskammer (3) verbunden ist, dass parallel zu dem genannten elektrischen Eingang der Spannungsdatengeber (5) und ein Element (6) zum Unterbrechen der Bogenentladungen geschaltet ist, dass der zweite Eingang des ersten Vergleichselementes (9) mit dem ersten Ausgang eines Programmierelementes (10) für die vorgegebene Temperatur der Werkstücke (7) verbunden ist, dass der Ausgang des ersten Reglers (11) mit dem ersten Eingang des Addierelementes (12) verbunden ist, dass der Ausgang des Addierelementes (12) mit dem ersten Eingang eines zweiten Vergleichselementes (13) verbunden ist, dass der zweite Eingang des zweiten Vergleichselementes (13) mit dem Ausgang des Stromdatengebers (2) und sein Ausgang mittels eines zweiten Reglers (14) mit dem Steuereingang der Gleichspannungsquelle (1) verbunden ist, dass der Ausgang des dritten Reglers (17) mit dem zweiten Eingang des Addierelementes (12) verbunden ist, dass der Ausgang des Spannungsdatengebers (5) mittels eines Amplitudendetektors (19) mit dem ersten Eingang eines vierten Vergleichselementes (20) verbunden ist, dass das vierte Vergleichselement (20) mittels eines vierten Reglers (21) mit dem ersten Eingang eines Umschalters (22) verbunden ist, dass der Steuereingang des Umschalters (22) mit dem zweiten Ausgang für vorgegebenes Behandlungsgas des Programmierelementes (10) verbunden ist, dass der dritte Ausgang des Programmierelementes (10) zur Vorgabe des Amplitudenwertes der Spannung mit dem zweiten Eingang des vierten Vergleichselementes (20) vebunden ist, dass die Ausgänge der Behandlungsgasquelle mit den Gaseingängen von mindestens zwei Ausführungsorganen (24 bzw. 25) zur Regelung der Durchflussmenge verbunden sind, deren Ausgänge mit dem Gaseingang der Arbeitskammer (3) verbunden sind, und dass die Eingänge zur Steuerung der die Durchflussmenge regulierenden Organe (24 bzw. 25) mit den entsprechenden Ausgängen des Umschalters (22) verbunden sind.

**Claims**

1. Procedure for controlling the chemical-thermal processing of workpieces by means of glow discharge in an atmosphere of process gases, by means of heating the workpieces at the same time as intensive cathodic sputtering of their surfaces, and by means of diffusion enrichment of the workpieces, the temperature of the workpieces and the frequency of the arising arc discharges being measured, the measured values being compared with predetermined values and error signals being produced therefrom which serve to produce control signals, characterised in that while the workpieces are heated at the same time as the intensive cathodic sputtering of their surfaces, the voltage of the glow discharge has at least one constant value which corresponds to a predetermined value at which the cathodic sputtering of the workpieces occurs with predetermined intensity, in that during the diffusion enrichment of the workpieces at predetermined temperature, the voltage of the glow discharge has another at least one constant value which corresponds to at least a predetermined value, at which the desired properties of the workpieces are maintained, in that during the cooling the voltage of the glow discharge has at least a third constant value which corresponds to at least a predetermined value at which the final properties of the workpieces are maintained, in that during the mentioned steps in the procedure, the frequency of the arising arc discharges has an arbitrary value the magnitude of which is limited to a predetermined constant value of the frequency of the arc discharges, in that the temperature of the workpieces always corresponds to a predetermined increasing, then constant, and then decreasing value which, together with the one mentioned, guarantees at least a predetermined value of the voltage of the glow discharge, the predetermined intensity of the cathodic sputtering and the desired final properties of the workpieces, in that during the steps in the procedure, process gases are used in a sequence which corresponds to the series of predetermined voltage values of the glow discharge, which voltage is controlled by the passage of the process gases, in that during each step in the procedure, apart from the temperature of the workpieces and the frequency of the arising arc discharges, the current of the glow discharge and the amplitude value of the voltage of the glow discharge are also measured, in that apart from the measured temperature values of the workpieces and apart from the frequency of the arc discharges, the current of the glow discharge and the amplitude value of the voltage of the glow discharge are also compared with their predetermined values, and corresponding control signals for the temperature and the frequency are obtained from the received error signals for the temperature and frequency and are summated, in that the addition signal is compared with a signal proportional to the discharge current, and in that an error signal is thereby obtained and a control signal for the voltage of the glow discharge is produced by the error signal, so that the current of the glow discharge corresponds to the addition signal of the control signals of the temperature and of the frequency according to a PID-law, and a controlling signal for the passage of the process gas is produced from the error signal of the amplitude value of the voltage of the glow discharge, so that the amplitude value of the voltage of the glow discharge corresponds to the specified value according to a further PID-law.

2. Apparatus for controlling the chemical-thermal processing of workpieces with glow discharge in an atmosphere of process gas, for carrying out the procedure according to claim 1, with a direct-voltage supply (1), with a working chamber (3) to contain the workpieces (7) which are connected, in a heat-conducting manner, to a temperature-data sensor (8) which is connected to a first regulator (11) by means of a first comparison element (9), the gas outlet of the working chamber (3) being connected to the outer atmosphere by means of a vacuum pump (26), and to a voltage-data sensor (5), the output of which is connected to the input of a third regulator (17) by means of a series-connected frequency-voltage converter (15) and by means of a third comparison element (16), and a supply (18), for a specified constant value of the frequency of the arc discharges, being connected to the second input ot the third comparison element (16), characterised in that one pole of the direct-voltage supply (1) is connected to the coresponding pole of the electrical input of the working chamber (3) by means of a current-data sensor (2), in that the other pole of the direct-voltage supply (1) is connected to the other pole of the electrical input of the working chamber (3) by means of a smoothing choke (4), in that parallel to the electrical input mentioned, the voltage-data sensor (5) and an element (6) to interrupt the arc discharges are connected, in that the second input of the first comparison element (9) is connected to the first output of a programming element (10) for the predetermined temperature of the workpieces (7), in that the output of the first regulator (11) is connected to the first input of the addition element (12), in that the output of the addition element (12) is connected to the first input of a second comparison element (13), in that the second input of the second comparison element (13) is connected to the output of the current-data sensor (2) and its output is connected to the control input of the direct-voltage supply (1) by means of a second regulator (14), in that the output of the third regulator (17) is connected to the second input of the addition element (12), in that the output of the voltage-data sensor (5) is connected to the first input of a fourth comparison element (20) by means of an amplitude detector (19), in that the fourth comparison element (20) is connected to the first input of a change-over switch (22) by means of a fourth regulator (21), in that the control input of the change-over switch (22) is connected to the second output for predetermined process gas of the programming element (10), in that the third output of the programming element (10), to stipulate the amplitude value of the voltage, is connected to the second input of the fourth comparison element (20), in that the outlets of the process gas supply are connected to the gas inlets of at least two constructional parts (24 or 25) to regulate the flow rate, the outlets of which are connected to the gas inlet of the working chamber (3), and in that the inputs for controlling the parts (24 or 25) which regulate the flow rate, are connected to the corresponding outputs of the change-over switch (22).

## Revendications

1. Procédé pour commander le traitement chimico-thermique de pièces à traiter au moyen d'une décharge à effluve dans une atmosphère de gaz de traitement, par chauffage des pièces à traiter moyennant une pulvérisation cathodique intense simultanée de leur surface, et par enrichissement par diffusion des pièces à traiter, selon lequel on mesure la température des pièces à traiter et la fréquence des décharges en arc qui apparaissent, et on compare les valeurs mesurées aux valeurs prédéterminées et on forme à partir de là des signaux d'erreur qui servent à produire des signaux de commande, caractérisé en ce que pendant le chauffage des pièces à traiter moyennant la pulvérisation cathodique intense simultanée de leur surface, la tension de la décharge à effluve possède au moins une valeur constante correspondant à une valeur prédéterminée, pour laquelle la pulvérisation cathodique des pièces à traiter se déroule avec une intensité prédéterminée, en ce que pendant l'enrichissement par diffusion des pièces à traiter à une température prédéterminée, la tension de la décharge à effluve possède une autre valeur, au moins une valeur constante correspondant au moins à une valeur prédéterminée, pour laquelle on obtient les propriétés désirées des pièces à traiter, en ce que pendant le refroidissement, la tension de la décharge à effluve possède au moins une troisième valeur constante correspondant au moins à une valeur prédéterminée, pour laquelle on obtient les propriétés définitives des pièces à traiter, en ce que pendant les étapes opératoires indiquées, la fréquence des décharges en arc qui apparaissent possède une valeur quelconque, qui est limitée à une valeur constante prédéterminée des fréquences des décharges en arc, en ce que la température des pièces à traiter correspond toujours à une valeur prédéterminée croissante, constante et décroissante, qui, conjointement avec la valeur mentionnée, à savoir au moins une valeur prédéterminée de la tension de la décharge à effluve, garantit l'intensité prédéterminée de la pulvérisation cathodique et les propriétés finales recherchées des pièces à traiter, en ce que pendant les étapes opératoires, on utilise des gaz de traitement selon une séquence qui correspond à la série de valeurs de tension prédéterminées de la décharge à effluve, laquelle tension est commandée par le débit des gaz de traitement, en ce que pendant chaque étape opératoire, on mesure, en dehors de la température des pièces à traiter et de la fréquence des décharges en arc qui apparaissent, également le courant de la décharge à effluve et la valeur de l'amplitude de la tension de la décharge à effluve, en ce qu'en dehors des valeurs de température mesurées des pièces à traiter et de la fréquence des décharges en arc, on compare également le courant de la décharge à effluve et la valeur de l'amplitude de la tension de la décharge à effluve à leurs valeurs prédéteminées et on obtient à partir des signaux d'erreur obtenus pour la température et la fréquence, des signaux de commande correspondants pour la température et la fréquence et on les additionne, en ce qu'on compare le signal somme à un signal proportionnel au courant de décharge et en ce qu'on obtient de ce fait un signal d'erreur et, à partir de ce dernier, un signal de commande pour la tension de la décharge en arc de telle sorte que le courant de cette décharge en arc correspond au signal somme des signaux de commande de la température et de la fréquence conformément à une loi proportionnelle, intégrale et différentielle et qu'on obtient, à partir du signal d'erreur de la valeur d'amplitude de la tension de la décharge en effluve, un signal de commande pour le débit du gaz de traitement, de sorte que la valeur d'amplitude de la tension de la décharge en effluve correspond à la valeur prédéterminée conformément à une autre loi proportionnelle, intégrale et différentielle.

2. Dispositif pour commander le traitement chimico-thermique de pièces à traiter à l'aide d'une décharge à effluve dans une atmosphère d'un gaz de traitement, pour la mise en oeuvre du procédé selon la revendication 1, comportant une source de tension continue (1), une chambre de travail (3) pour la réception des pièces à traiter (7) qui sont reliées d'une manière thermoconductrice à un générateur de données de température (8) qui est relié à un premier régulateur (11) au moyen d'un premier élément comparateur (9), la sortie du gaz hors de la chambre de travail (3) étant reliée au moyen d'une pompe à vide (26) à l'atmosphère extérieure, et un générateur de données de tension (5), dont la sortie est reliée par l'intermédiaire d'un convertisseur fréquence-tension (15), branché en série, et d'un troisième élément comparateur (16), à l'entrée d'un troisième régulateur (17), et dans lequel une source (18) délivrant une valeur constante prédéterminée de la fréquence des décharges en arc est reliée à la seconde entrée du troisième élément comparateur (16), caractérisé en ce qu'un pôle de la source de tension continue (1) est reliée par l'intermédiaire d'un générateur de données de courant (2) au pôle correspondant de l'entrée électrique de la chambre de travail (3), en ce que l'autre pôle de la source de tension continue (1) est relié au moyen d'une bobine de lissage (4) à l'autre pôle de l'entrée électrique de la chambre de travail (3), en ce que le générateur de données de tension (5) et un élément (6) servant à interrompre les décharges en arc sont branchés en parallèle avec l'entrée électrique indiquée, en ce que la seconde entrée du premier élément comparateur (9) est reliée à la première sortie d'un élément de programmation (10) pour la température prédéterminée des pièces à traiter (7), en ce que la sortie du premier régulateur (11) est reliée à la première entrée de l'élément additionneur (12), en ce que la sortie de l'élément additionneur (12) est reliée à la première entrée d'un second élément comparateur (13), en ce que la seconde entrée du second élément comparateur (13) est reliée à la sortie du générateur de données de courant (2) et en ce que sa sortie est reliée au moyen d'un second régulateur (14) à l'entrée de commande de la source de tension continue (1), en ce que la sortie du troisième régulateur (17) est reliée à la seconde entrée de l'élément additionneur (12), en ce que la sortie du générateur de données de tension (5) est reliée au moyen d'un détecteur d'amplitude (19) à la première entrée d'un élément comparateur (20), en ce que la quatrième élément comparateur (20) est relié au moyen d'un quatrième régulateur (21) à la première entrée d'un commutateur (22), en ce que l'entrée de commande du commutateur (22) est reliée à la seconde sortie pour le gaz de traitement prédéterminé de l'élément de programmation (10), en ce que la troisième sortie de l'élément de programmation (10) est reliée, pour la prédétermination de la valeur d'amplitude de la tension, à la seconde entrée du quatrième élément comparateur (20), en ce que les sorties de la source de gaz de traitement sont raccordées aux entrées du gaz d'au moins deux unités d'exécution (24 ou 25) qui servent à régler le débit et dont les sorties sont raccordées à l'entrée du gaz de la chambre de travail (3), et en ce que les entrées utilisée pour la commande des unités (24 ou 25) réglant le débit sont reliées aux sorties correspondantes du commutateur (22).

Fig 1

Fig 2

EP 0 183 230 B1